# EUROPÄISCHE PATENTANMELDUNG

(11) **EP 4 783 821 A1**
(43) Veröffentlichungstag der Anmeldung: **29.07.2026**
(21) Anmeldenummer: 26152488.8
(22) Anmeldetag: 16.01.2026
(51) Int. Cl.: H10W 72/00, H10W 72/50, H10W 90/00

(54) **LEISTUNGSMODUL**

(30) Priorität: 27.01.2025 DE 102025102870
(71) Anmelder: Volkswagen Aktiengesellschaft, 38440 Wolfsburg (DE)
(72) Erfinder: Bayer, Dr. Christoph Friedrich, 38440 Wolfsburg (DE); Wilke, Dr. Robert, 38440 Wolfsburg (DE); Zeinel, Denis, 38440 Wolfsburg (DE); Dedeleit, Dr. Lukas, 38440 Wolfsburg (DE)

(57) **Zusammenfassung**

Die Erfindung betrifft ein Leistungsmodul (1), umfassend einen Träger (2) und mindestens zwei Leistungshalbleiter (5), wobei der Träger (2) eine Isolationsschicht (3) und mindestens eine strukturierte Metallisierung (4) auf einer Oberseite aufweist, wobei die Leistungshalbleiter (5) mit einer Unterseite auf der strukturierten Metallisierung (4) angeordnet sind und auf der Oberseite elektrisch verbunden sind, wobei die Oberseite der mindestens zwei Leistungshalbleiter (5) mit jeweils einem Clip (9) kontaktiert sind, wobei die Clips (9) mittels mindestens einem Bonddraht (6) oder Bondbändchen miteinander kontaktiert sind.

## Beschreibung

Die Erfindung betrifft ein Leistungsmodul, umfassend einen Träger und mindestens zwei Leistungshalbleiter.

Derartige Leistungsmodule finden in verschiedenen Bereichen Anwendung. Ein Anwendungsbereich ist beispielsweise als Teil eines Wechselrichters, beispielsweise eines Wechselrichters in einem Traktionsnetz eines Kraftfahrzeugs.

Typischerweise umfasst ein Leistungsmodul einen Träger, wobei der Träger eine Isolationsschicht und mindestens eine strukturierte Metallisierung aufweist. Die Isolationsschicht ist beispielsweise eine Keramik. Die strukturierte Metallisierung ist beispielsweise aus Kupfer oder Aluminium. Die strukturierte Metallisierung ist auf einer Oberseite der Isolationsschicht aufgebracht. Auf der Unterseite kann ebenfalls eine Metallisierung aufgebracht sein, die beispielsweise zur thermischen Anbindung an einen Kühlkörper dient. Auf die strukturierte Metallisierung werden dann die Leistungshalbleiter in Form von bare dies aufgebracht, die hierzu an der Unter- und Oberseite Kontakte aufweisen. Dabei werden die Leistungshalbleiter mit der Unterseite auf die strukturierte Metallisierung aufgebracht und beispielsweise verlötet. Dabei sind Verschaltungen der mindestens zwei Leistungshalbleiter bekannt, wo diese auf der Oberseite miteinander elektrisch verbunden werden müssen. Eine solche Verschaltung ist beispielsweise die Parallelschaltung von High-Side- oder Low-Side-Schaltern einer Halbbrücke, wo die Stromtragfähigkeit eines einzelnen Leistungshalbleiters zu gering ist. Für die oberseitige Verbindung der Leistungshalbleiter sind prinzipiell zwei Verbindungsmöglichkeiten möglich. Eine Möglichkeit sind Bonddrähte. Über die Bonddrähte kann dann eine Querverbindung realisiert werden zwischen den Leistungshalbleitern und zusätzlich zu einer oder mehreren Metallstrukturen der strukturierten Metallisierung. Die Verbindung mit Bonddrähten ist eine prinzipiell sehr einfache Verbindungstechnik. Allerdings findet das Schneiden der Bonddrähte auf den bare dies statt, sodass hier verstärkte Anforderungen an die Prozessgenauigkeit gestellt sind, um den bare die (bzw. Leistungshalbleiter) nicht zu beschädigen. Eine andere Art der elektrischen Verbindung stellen Clips dar. Ein Clip stellt dabei eine gegebenenfalls geformte Metallfolie oder ein Metallblech dar. Der Clip ist dabei derart geformt, sowohl die Verbindung zwischen den Oberseiten der Leistungshalbleiter herzustellen als auch gegebenenfalls zu einer oder mehreren Metallstrukturen auf der strukturierten Metallisierung. Ein Vorteil derartiger Clip-Verbindungen ist die sehr niederinduktive Anbindung, was zu einem verbesserten Schaltverhalten führt, sodass das Problem der Inter-Clip-Oszillation reduziert wird (schwingungsverhalten beim Schalten). Nachteilig ist der höhere Fertigungsaufwand, da der Clip gleichzeitig zu allen Leistungshalbleitern genau ausgerichtet werden muss.

Leistungsmodule mit Clips sind beispielsweise aus der EP 4 002 447 A1, der US 10 043 736 B2 oder der US 7 683 465 B2 bekannt.

Der Erfindung liegt das technische Problem zugrunde, ein gattungsgemäßes Leistungsmodul zu schaffen, das einfach in der Fertigung ist und Inter-Chip-Oszillationen reduziert.

Die Lösung des technischen Problems ergibt sich durch ein Leistungsmodul mit den Merkmalen des Anspruchs 1. Weitere vorteilhafte Ausgestaltungen der Erfindung ergeben sich aus den Unteransprüchen.

Das Leistungsmodul umfasst einen Träger und mindestens zwei Leistungshalbleiter, wobei der Träger eine Isolationsschicht und mindestens eine strukturierte Metallisierung auf einer Oberseite aufweist. Die Leistungshalbleiter sind mit einer Unterseite auf der strukturierten Metallisierung angeordnet und auf der Oberseite elektrisch verbunden. Dabei sind die Oberseiten der mindestens zwei Leistungshalbleiter jeweils mit einem Clip kontaktiert, wobei die Clips mittels mindestens einem Bonddraht oder Bondbändchen miteinander kontaktiert sind. Anschaulich werden somit die beiden zuvor beschriebenen Verbindungstechniken kombiniert. Die Positionierung von Clips, die nur einen Leistungshalbleiter kontaktieren, ist relativ einfach, wobei die Verbindung aufgrund der flächigen Ausdehnung des Clips niederinduktiv ist. Durch die Verbindung der Clips durch den mindestens einen Bonddraht bzw. Bondbändchen wird die parisitäre Induktivität weiter reduziert. Dabei kommen vorzugsweise mehrere Bonddrähte bzw. Bondbändchen zum Einsatz, die neben der Signalübertragung auch zur mechanischen Befestigung dienen. Dabei sind die Bondprozesse unkritisch, da auf die Clips gebondet und dort auch der Bonddraht geschnitten wird, wobei Einschnitte in den Clip unkritisch sind. Die Leistungshalbleiter können mit ihren Unterseiten auf derselben Metallstruktur angeordnet sein, was aber nicht zwingend ist. Die Clips sind vorzugsweise mit einer weiteren Metallstruktur verbunden. Dabei können alle Clips mit der gleichen Metallstruktur verbunden sein. Es sind aber auch Ausführungen möglich, wo die Clips mit verschiedenen Metallstrukturen verbunden sind.

In einer Ausführungsform sind alle Clips gleichartig ausgebildet, d.h. diese weisen das gleiche Material und gleiche Abmessungen auf, was die Fertigung vereinfacht.

Die Clips können darüber hinaus auch als Träger weiterer Komponenten genutzt werden.

In einer Ausführungsform ist auf mindestens einem Clip eine Pinhülse angeordnet. In diese Pinhülse kann ein Signalkontakt eingepresst oder verlötet werden, über den das Potential am Leistungshalbleiter abgegriffen werden kann. Die Auswertung erfolgt dann beispielsweise über eine separate Leiterplatte über oder neben dem Leistungsmodul. Da die Clips elektrisch miteinander verbunden sind, reicht prinzipiell eine Pinhülse.

In einer weiteren Ausführungsform ist auf mindestens einem Clip ein Temperatursensor angeordnet, der vorzugsweise als NTC-Widerstand ausgebildet ist.

In einer weiteren Ausführungsform ist auf allen Clips ein Temperatursensor angeordnet, sodass die Temperatur von allen Leistungshalbleitern separat erfasst wird.

In einer weiteren Ausführungsform sind die Leistungshalbleiter als SiC-MOSFETs ausgebildet.

Die Erfindung wird nachfolgend anhand eines bevorzugten Ausführungsbeispiels näher erläutert. Die Figuren zeigen:
- Fig. 1: eine schematische Darstellung eines Teils eines Leistungsmoduls,
- Fig. 2: eine nicht anspruchsgemäße Darstellung eines Teils eines Leistungsmoduls und
- Fig. 3: eine weitere nicht anspruchsgemäße Darstellung eines Teils eines Leistungsmoduls.

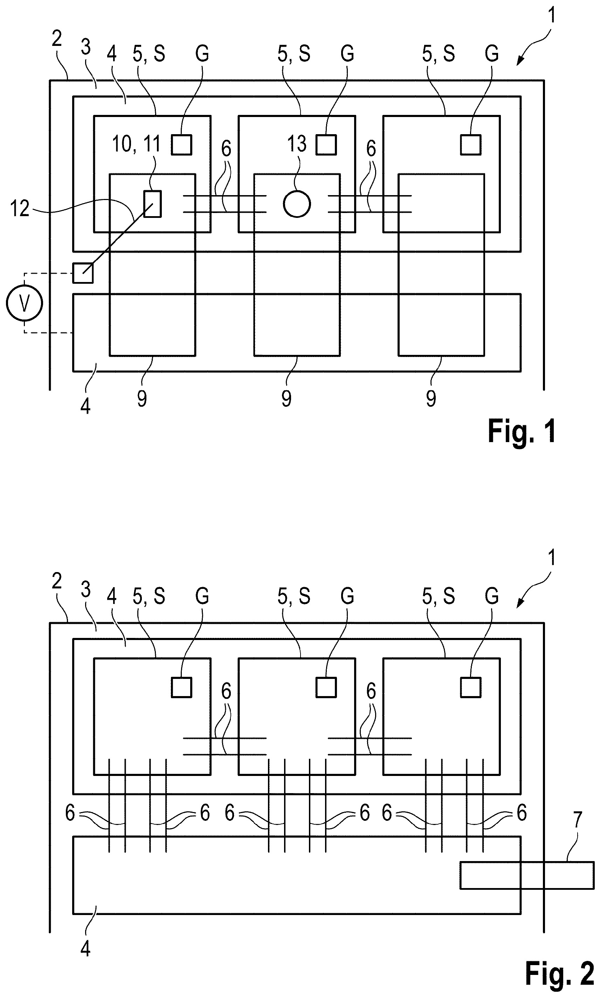

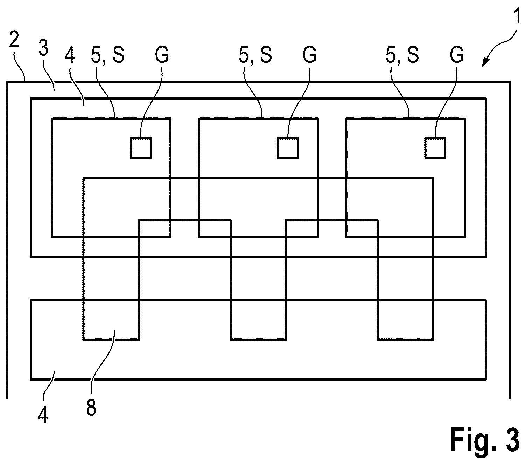

Bevor die Erfindung erläutert wird, soll zunächst kurz anhand von Fig. 2 und Fig. 3 der Stand der Technik erläutert werden. In der Fig. 2 ist ein Teil eines Leistungsmoduls 1 dargestellt. Das Leistungsmodul 1 weist einen Träger 2 auf, der eine Isolationsschicht 3 und eine strukturierte Metallisierung 4 auf der Oberseite der Isolationsschicht 3 aufweist. Die Isolationsschicht 3 ist beispielsweise als Keramik ausgebildet. Auf einer ersten Struktur der strukturierten Metallisierung 4 sind drei Leistungshalbleiter 5 angeordnet, die beispielsweise als SiC-MOSFETs ausgebildet sind. Die Unterseite der Leistungshalbleiter 5 weist z.B. jeweils einen Drain-Kontakt auf, wobei auf der jeweiligen Oberseite ein Source-Kontakt S und ein Gate-Kontakt G angeordnet sind. Über Bonddrähte 6 sind die Source-Kontakte S jeweils mit einer anderen Struktur der strukturierten Metallisierung 4 verbunden. Des Weiteren sind die Source-Kontakte S über Bonddrähte 6 miteinander verbunden. Weiter dargestellt ist ein Leadframe 7, das mit der anderen Struktur verbunden ist, um ein Spannungspotential abzugreifen. Nicht dargestellt sind die Anschlüsse für die Gate-Kontakte G, die ebenfalls über Bonddrähte erfolgen.

In der Fig. 3 ist eine alternative Ausführungsform dargestellt, wobei die Verbindung der Source-Kontakte S mit der anderen Struktur über einen Clip 8 erfolgt, der alle drei Leistungshalbleiter 5 untereinander sowie mit der anderen Struktur ermöglicht.

In der Fig. 1 ist nun ein erfindungsgemäßes Leistungsmodul 1 dargestellt. Dabei sind die Source-Kontakte S der Leistungshalbleiter 5 jeweils über einen Clip 9 mit der anderen Struktur der strukturierten Metallisierung 4 verbunden, wobei alle Clips 9 gleichartig ausgebildet sind. Zusätzlich sind benachbarte Clips 9 über Bonddrähte 6 miteinander elektrisch und mechanisch verbunden. Dies vereinfacht die Montage, da die Justierung der Clips 9 vereinfacht ist und die Bonddrähte 6 auf die Clips 9 gebondet werden. Zusätzlich kann die Fläche der Clips dazu ausgenutzt werden, weitere Bauelemente anzuordnen. So ist auf einem Clip 9 ein Temperatursensor 10 angeordnet, der beispielsweise als NTC-Widerstand 11 ausgebildet ist. Über einen Bonddraht 12 ist der Temperatursensor 10 mit einer weiteren Struktur der strukturierten Metallisierung 4 verbunden. Gestrichelt ist ein Voltmeter V dargestellt, um die Spannung und damit die Temperatur des Temperatursensors 10 zu erfassen. Weiter dargestellt ist eine Pinhülse 13, die auf einem Clip 9 aufgebracht ist, sodass ein Signalkontakt in die Pinhülse 13 eingesteckt werden kann.

### Bezugszeichenliste

- 1: Leistungsmodul
- 2: Träger
- 3: Isolationseinheit
- 4: strukturierte Metallisierung
- 5: Leistungshalbleiter
- 6: Bonddraht
- 7: Leadframe
- 8: Clip
- 9: Clip
- 10: Temperatursensor
- 11: NTC-Widerstand
- 12: Bonddraht
- 13: Pinhülse
- S: Source-Kontakt
- G: Gate-Kontakt

## Patentansprüche

1. Leistungsmodul (1), umfassend einen Träger (2) und mindestens zwei Leistungshalbleiter (5), wobei der Träger (2) eine Isolationsschicht (3) und mindestens eine strukturierte Metallisierung (4) auf einer Oberseite aufweist, wobei die Leistungshalbleiter (5) mit einer Unterseite auf der strukturierten Metallisierung (4) angeordnet sind und auf der Oberseite elektrisch verbunden sind,
**dadurch gekennzeichnet, dass**
die Oberseite der mindestens zwei Leistungshalbleiter (5) mit jeweils einem Clip (9) kontaktiert sind, wobei die Clips (9) mittels mindestens einem Bonddraht (6) oder Bondbändchen miteinander kontaktiert sind.

2. Leistungsmodul nach Anspruch 1, **dadurch gekennzeichnet, dass** die Clips (9) gleichartig ausgebildet sind.

3. Leistungsmodul nach Anspruch 1 oder 2, **dadurch gekennzeichnet, dass** auf mindestens einem Clip (9) eine Pinhülse (13) angeordnet ist.

4. Leistungsmodul nach einem der vorangegangenen Ansprüche, **dadurch gekennzeichnet, dass** auf mindestens einem Clip (9) ein Temperatursensor (10) angeordnet ist.

5. Leistungsmodul nach Anspruch 4, **dadurch gekennzeichnet, dass** der Temperatursensor (10) als NTC-Widerstand (11) ausgebildet ist.

6. Leistungsmodul nach Anspruch 4 oder 5, **dadurch gekennzeichnet, dass** auf allen Clips (9) ein Temperatursensor (10) angeordnet ist.

7. Leistungsmodul nach einem der vorangegangenen Ansprüche, **dadurch gekennzeichnet, dass** die Leistungshalbleiter (5) als SiC-MOSFETs ausgebildet sind.
